# EUROPÄISCHE PATENTSCHRIFT

(11) **EP 0 442 149 B1**
(45) Veröffentlichungstag und Bekanntmachung des Hinweises auf die Patenterteilung: **01.03.1995**
(21) Anmeldenummer: 90125773.3
(22) Anmeldetag: 28.12.1990
(51) Int. Cl.: G01R 1/073

(54) **Verfahren und Vorrichtung zum Laden eines Adapters für ein Leiterplattenprüfgerät**
Device and method for charging an adapter for a printed circuit board testing device
Dispositif et procédé pour munir un adaptateur pour un dispositif de test de circuits imprimés

(30) Priorität: 16.02.1990 DE 4004933; 12.11.1990 DE 4035978
(43) Veröffentlichungstag der Anmeldung: 21.08.1991
(73) Patentinhaber: Luther & Maelzer GmbH, D-31515 Wunstorf (DE)
(72) Erfinder: Maelzer, Martin, W-3050 Wunstorf (DE); Higgen, Hans-Hermann, W-3060 Stadthagen (DE); Dehmel, Rüdiger, W-3050 Wunstorf (DE); Gladik, Heimo, W-7909 Dornstadt-Temmenhausen (DE)
(74) Vertreter: Schmidt-Evers, Jürgen, Dipl.-Ing.

(56) Entgegenhaltungen:
- EP-A- 0 144 682
- EP-A- 0 164 722
- EP-A- 0 238 886
- EP-A- 0 315 707

## Beschreibung

Die Erfindung betrifft ein Verfahren und eine Vorrichtung nach den Oberbegriffen der Patentansprüche 1 und 13 zum Laden eines Adapters für ein Leiterplattenprüfgerät.

In der EP-A-0 238 886 ist eine Vorrichtung zum Bestücken eines Adapters mit Kontaktnadeln für eine Leiterplatten-Prüfeinrichtung beschrieben. Diese bekannte Vorrichtung umfaßt ein Nadelmagazin, einen Zwischenadapter und eine dazwischen angeordnete Führungsplatte mit Führungsbohrungen für die Kontaktnadeln. Dabei handelt es sich bei dem Zwischenadapter nicht um ein Zwischenmagazin sondern um ein Bauteil eines zugehörigen Adapters, in den der Zwischenadapter einsetzbar ist, siehe Spalte 3, Zeilen 40 bis 42. Für einen Bestückungsvorgang des Zwischenadapters werden das vollständig bestückte Kontaktnadelmagazin mit der Führungsplatte und dem Zwischenadapter verbunden. Danach wird die gesamte Anordnung um 180° gedreht, so daß die mit ihren Spitzen nach unten gerichteten Kontaktnadeln bis zur Führungsplatte fallen und auf dieser mit ihren Spitzen aufliegen. Dort, wo ein Prüfpunkt vorgesehen ist, fallen die Nadeln in die zugehörige Führungsbohrung in der Führungsplatte, können aber noch nicht durch die Führungsplatte fallen. Erst wenn das Kontaktnadelmagazin angehoben wird und dadurch die Kontaktnadeln aus letztere aufnehmenden Zellen im Kontaktnadelmagazin soweit nach unten rutschen, daß sie mit einem in ihrem oberen Bereich vorgesehenen Ring oder Kopf aus den Bohrungen einer oberen Magazinplatte herauskommen, erhalten sie soviel horizontales Spiel, daß sie sich seitlich neigen und in die zugehörigen Führungsbohrungen fallen können. Bei diesem bekannten Verfahren und dieser bekannten Vorrichtung werden somit die Kontaktnadeln mit ihren Nadelspitzen zuerst in den ein Teil des Adapters bildenden Zwischenadapter eingeführt.

Aus der Druckschrift EP-A-0 144 682 ist es bekannt, Adapterstifte an ihren Köpfen hängend an einer Haltevorrichtung zu halten, von der sie durch Schwerkraft selbsttätig zunächst in eine Ausrichtungsvorrichtung und dann in einen Adapter fallen können.

Aus der Praxis sind ein Verfahren und eine Vorrichtung der eingangs angegebenen Arten bekannt, die für jede Ausführung der Adapterstifte ein eigenes Hauptmagazin und je ein zugeordnetes Zwischenmagazin sowie ein gemeinsames sogenanntes Verriegelungspaket verwenden. Die Selektionsplatte ist auf dem Zwischenmagazin befestigt. Der Durchmesser der Löcher im Hauptmagazin, im Zwischenmagazin einschl. der Selektionsplatte sowie im Verriegelungspaket ist kleiner als der Durchmesser der Köpfe und wenigstens gleich dem der Schäfte der Adapterstifte. Auf diese Weise hängen die Adapterstifte an ihren Köpfen im Hauptmagazin, im Zwischenmagazin bzw. im Verriegelungspaket.

Die Verfahrensschritte zum Überführen einer ersten Ausführung von Adapterstiften aus einem ersten Hauptmagazin in den Adapter sind wie folgt:
1. Transportieren des mit den Adapterstiften gefüllten Hauptmagazins unter das geöffnete Verriegelungspaket,
2. Anheben und damit Überführen der Adapterstifte in das Verriegelungspaket durch Anheben derselben mittels einer von unten gegen das Hauptmagazin bewegten lochfreien Platte,
3. Schließen des Verriegelungspakets zum Festhalten der überführten Adapterstifte,
4. Entfernen des vollständig geleerten Hauptmagazins,
5. Transportieren des leeren Zwischenmagazins mit nach oben weisender Selektionsplatte unter das geschlossene Verriegelungspaket,
6. öffnen des Verriegelungspakets, so daß die in den Adapter zu ladenden Adapterstifte mit ihren Kontaktenden voraus durch die Selektionsplatte in das Zwischenmagazin fallen,
7. Schließen des Verriegelungspakets zum Festhalten der verbleibenden Adapterstifte,
8. Entfernen des beladenen Zwischenmagazins,
9. Transportieren des leeren Hauptmagazins unter das geschlossene, teilgefüllte Verriegelungspaket,
10. öffnen des Verriegelungspakets, so daß die darin verbliebenen Adapterstifte mit ihren Kontaktenden voraus in das Hauptmagazin zurückfallen,
11. Entfernen des teilgefüllten Hauptmagazins,
12. Transportieren des beladenen zwischenmagazins unter das geöffnete leere Verriegelungspaket,
13. Anheben der Adapterstifte und Überführen derselben in das Verriegelungspaket in gleicher Weise wie im Verfahrensschritt 2,
14. Schließen des Verriegelungspakets zum Festhalten der überführten Adapterstifte,
15. Entfernen des leeren Zwischennagazins,
16. Transportieren des leeren Adapters unter das geschlossene, teilgefüllte Verriegelungspaket,
17. öffnen des Verriegelungspakets, so daß die darin befindlichen Adapterstifte mit ihren Kontaktenden voraus in den Adapter fallen,
18. Entfernen des gefüllten Adapters.

Diese 18 Verfahrensschritte werden unter Verwendung eines zweiten Zwischenmagazins wiederholt, wenn der Adapter zusätzlich mit einer zweiten Ausführung von Adapterstiften aus einem zweiten Hauptmagazin beladen werden soll.

Es ist Aufgabe der Erfindung, das Verfahren und die Vorrichtung der eingangs genannten Art so weiterzubilden, daß der Adapter einfacher und schneller sowie mit geringerem konstruktiven Aufwand beladen werden kann.

Diese Aufgabe wird erfindungsgemäß durch die kennzeichnenden Merkmale der Patentansprüche 1 und 13 gelöst. Auf diese Weise ist es möglich, die Anzahl der Verfahrensschritte von 18 bzw. 36 auf 6 bzw. 12 Schritte zu reduzieren und auch bei Beladen des Adapters mit Adapterstiften verschiedener Ausführungen lediglich ein Zwischenmagazin zu verwenden und auf das Verriegelungspaket völlig zu verzichten.

Das Überführen einer einzigen Ausführung von Adapterstiften erfolgt vorteilhafterweise mit den folgenden Verfahrensschritten:
1. Das leere Zwischenmagazin wird in Relativbewegung auf das volle Hauptmagazin aufgesetzt, wobei die Verschlußplatte an der dem Hauptmagazin gegenüberliegenden Oberseite des Zwischenmagazins und die Selektionsplatte zwischen dem Hauptmagazin und dem Zwischenmagazin angeordnet sind,
2. das Zwischenmagazin und das Hauptmagazin werden gemeinsam um etwa 180° gekippt, so daß die in den Adapter zu ladenden Adapterstifte mit den Köpfen voraus durch die Selektionsplatte in das Zwischenmagazin fallen,
3. das teilentleerte Hauptmagazin wird entfernt,
4. der leere Adapter wird mit seiner im beladenen Zustand die Köpfe der Adapterstifte haltenden Seite in Relativbewegung auf die der Verschlußplatte abgewandten Seite des beladenen Zwischenmagazins aufgesetzt,
5. der Adapter und das Zwischenmagazin werden gemeinsam um etwa 180° gekippt, so daß die Adapterstifte mit den Kontaktenden voraus in den Adapter fallen,
6. der beladene Adapter wird entfernt.
   Vorteilhafterweise wird der Adapter dann, wenn er zusätzlich mit Adapterstiften einer zweiten Ausführungsart beladen werden soll, um etwa 90° in eine Hochkantstellung gekippt. Es können sich dann die folgenden Verfahrensschritte anschließen:
7. Wiederholung des vorgenannten Verfahrensschritte 1, jedoch mit einem zweiten Hauptmagazin, das mit den Adapterstiften der zweiten Ausführungsart beladen ist,
8. Wiederholung des vorgenannten Verfahrensschrittes 2, jedoch mit dem zweiten Hauptmagazin,
9. Wiederholung des vorgenannten Verfahrensschrittes 3, jedoch mit dem zweiten Hauptmagazin,
10. das mit den Adapterstiften aus dem zweiten Hauptmagazin beladene Zwischenmagazin wird um etwa 90° in eine Hochkantstellung gekippt und in Relativbewegung an den bereits in die Hochkantstellung gekippten, mit Adapterstiften aus dem ersten Hauptmagazin beladenen Adapter angesetzt - dadurch wird verhindert, daß Adapterstifte aus dem Zwischenmagazin herausfallen, was der Fall wäre, wenn es um 180° gekippt würde, um es auf den in horizontaler Stellung nach dem Verfahrensschritt 6 befindlichen Adapter aufzusetzen,
11. das Zwischenmagazin und der Adapter werden gemeinsam um etwa 90° gekippt, so daß die Adapterstifte mit ihren Kontaktenden voraus in den Adapter fallen und das Zwischenmagazin leer zurückbleibt,
12. der vollständig beladene Adapter wird entfernt.

Es ist auch möglich, nach dem Überführen von Adapterstiften aus dem ersten Hauptmagazin in das Zwischenmagazin weitere in den Adapter zu ladende Adapterstifte aus einem oder mehreren weiteren Hauptmagazinen nacheinanderfolgend durch Schwerkrafteinwirkung mit den Köpfen voraus in das Zwischenmagazin zu überführen.

Dabei ist es zweckmäßig, das mit Adapterstiften aus wenigstens dem ersten Hauptmagazin beladenen Zwischenmagazin um etwa 90° in eine Hochkantstellung zu kippen und nach Ansetzen an ein weiteres, ebenfalls in Hochkantstellung befindliches Hauptmagazin zusammen mit diesem um etwa 90° zurückzukippen, so daß die Adapterstifte aus dem weiteren Hauptmagazin durch Schwerkrafteinwirkung in das Zwischenmagazin überführt werden. Nach Entfernung dieses Hauptmagazins erfolgen vorzugsweise die vorgenannten Verfahrensschritte 4 bis 6 oder 10 bis 12, letztere sinngemäß mit leerem Adapter und mit Adapterstiften aus dem ersten und dem weiteren Hauptmagazin beladenem Zwischenmagazin. Natürlich können die vorbeschriebenen Verfahrensschritte des Überführens der Adapterstifte vom Hauptmagazin in das Zwischenmagazin und in den Adapter mit jeweils zweimaligem Kippen um 90° in Abwandlung der Verfahrensschritte 1 bis 6 auch für das Beladen eines noch leeren Zwischenmagazins und noch leeren Adapters mit Adapterstiften aus dem ersten Hauptmagazin angewendet werden.

Gemäß einer Verfahrensvariante können die aus wenigstens einem Hauptmagazin in das Zwischenmagazin überführten Adapterstifte durch Schließen einer der Verschlußplatte benachbarten Klemmeinrichtung festgehalten werden, woraufhin das Zwischenmagazin mit den festgehaltenen Adapterstiften um etwa 180° gekippt und auf den Adapter aufgesetzt wird, so daß nach Öffnen der Klemmeinrichtung die Adapterstifte durch Schwerkrafteinwirkung mit den Kontaktenden voraus in den Adapter überführt werden. Auf diese Weise kann das Zwischenmagazin gemeinsam mit dem Adapter um 180° statt 2 x 90° gekippt werden.

Um den gleichen Vorteil bei der Überführung von Adapterstiften einer weiteren Ausführungsart in das Zwischenmagazin zu erzielen, wird nach dem Schließen der Klemmeinrichtung und Kippen um etwa 180° das beladene Zwischenmagazin vorzugsweise auf ein weiteres Hauptmagazin aufgesetzt und zusammen mit diesem wiederum um etwa 180° gekippt, so daß nach nochmaligem Lösen der Klemmeinrichtung die Adapterstifte aus dem weiteren Hauptmagazin durch Schwerkrafteinwirkung mit den Köpfen voraus in das Zwischenmagazin überführt werden.

Im Anschluß daran wird der Adapter mit seiner im beladenen Zustand die Köpfe der Adapterstifte haltenden Seite vorteilhafterweise auf die der Verschlußplatte abgewandte Seite des beladenen Zwischenmagazins aufgesetzt und zusammen mit diesem nach Schließen der Klemmeinrichtung um etwa 180° gekippt, so daß nach Lösen der Klemmeinrichtung die Adapterstifte mit den Kontaktenden voraus in den Adapter überführt werden.

Vorzugsweise umfaßt das Hauptmagazin wenigstens zwei mit gegenseitigem Abstand parallel zueinander angeordnete Lochplatten mit koaxial an den vorgenannten Rasterpunkten angeordneten Löchern, deren Durchmesser kleiner als der Durchmesser der Köpfe und zumindest gleich dem Durchmesser des jeweils aufzunehmenden Schaftabschnitts der Adapterstifte ist.

In entsprechender Weise kann das Zwischenmagazin ebenfalls aus wenigstens zwei mit gegenseitigem Abstand parallel zueinander angeordneten Lochplatten mit koaxial an den vorgenannten Rasterpunkten angeordneten Löchern mit einem Durchmesser umfassen, der zumindest gleich dem Durchmesser der Köpfe der Adapterstifte ist.

Vorzugsweise umfaßt die Klemmeinrichtung eine zwischen beiden Lochplatten angeordnete und in ihrer Ebene zwischen einer Offenstellung und einer Schließstellung verschiebbare Klemmplatte mit an den vorgenannten Rasterpunkten angeordneten Löchern, deren Durchmesser zumindest gleich dem Durchmesser der Köpfe der Adapterstifte ist, wobei die Löcher der Klemmplatte bei deren Offenstellung mittig und bei deren Schließstellung außermittig zu den Löchern der Lochplatten angeordnet sind. Dabei kann die Klemmplatte in Richtung Schließstellung federbeaufschlagt sein.

Das erfindungsgemäße Verfahren kann sowohl manuell als auch mechanisch durchgeführt werden. Für diesen Zweck ist eine Transportanordnung vorteilhaft, mit der das Hauptmagazin, das Zwischenmagazin und der Adapter relativ zueinander in Positionen transportiert werden, in denen Adapterstifte durch Schwerkrafteinwirkung aus dem Hauptmagazin in das Zwischenmagazin und aus diesem in den Adapter überführbar sind. Vorteilhafte Ausgestaltungen der Transportanordnung ergeben sich aus den Patentansprüchen 19 bis 29.

Nachstehend ist die Erfindung anhand dreier Verfahrensvarianten und zweier Ausführungsbeispiele einer Vorrichtung zur Durchführung des Verfahrens unter Bezugnahme auf die Zeichnung näher beschrieben.

Es zeigen
- Fig. 1-11: das erste Ausführungsbeispiel der Vorrichtung sowie eine Aufeinanderfolge der Verfahrensstufen der ersten Verfahrensvariante, wobei die Hauptmagazine bzw. der Adapter in den Fig. 1, 5 und 9 in der Draufsicht und in den Fig. 2-4, 6-8 sowie 10 und 11 im Schnitt entlang der Linie II-II in Fig. 1, VI-VI in Fig. 5 bzw. X-X in Fig. 9 sowie das Zwischenmagazin durchweg im Schnitt dargestellt sind,
- Fig. 12-15: eine Aufeinanderfolge der Verfahrensstufen der zweiten Verfahrensvariante in schematischer Darstellung,
- Fig. 16-21: eine Aufeinanderfolge der Verfahrensstufen der dritten Verfahrensvariante in schematischer Darstellung,
- Fig. 22 und 23: abgebrochene Schnittdarstellungen des Zwischenmagazins nach den Fig. 16-21, und
- Fig. 24: eine perspektivische Darstellung des zweiten Ausführungsbeispiels der Vorrichtung.

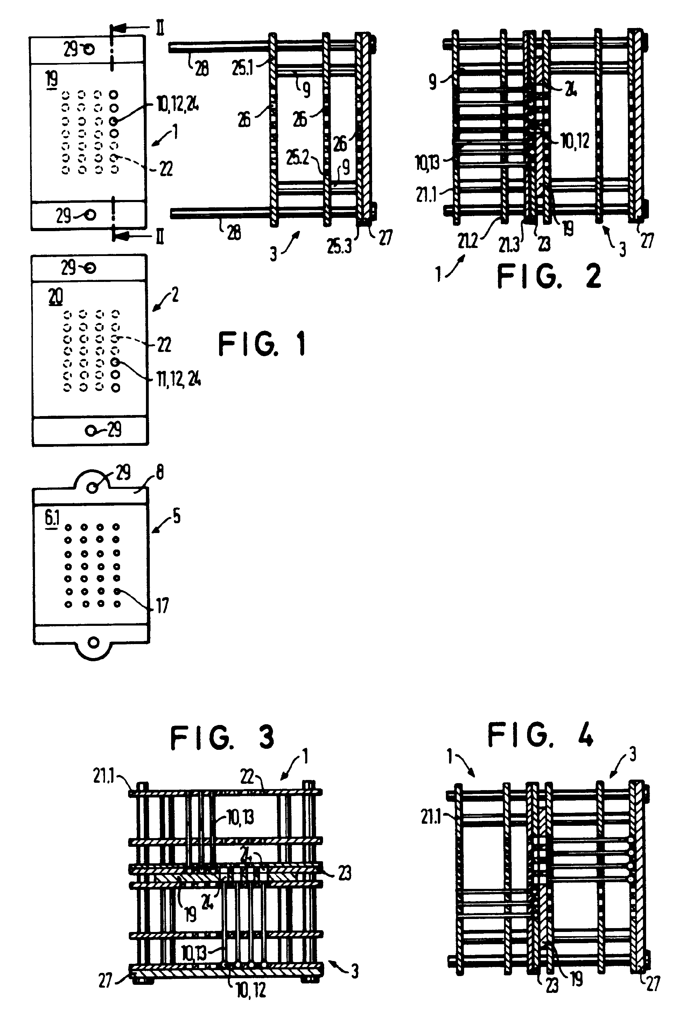

Die erfindungsgemäße Vorrichtung gemäß den Fig. 1-23 umfaßt zwei Hauptmagazine 1, 2 und ein Zwischenmagazin 3 bzw. 4 zum Beladen eines Adapters 5.

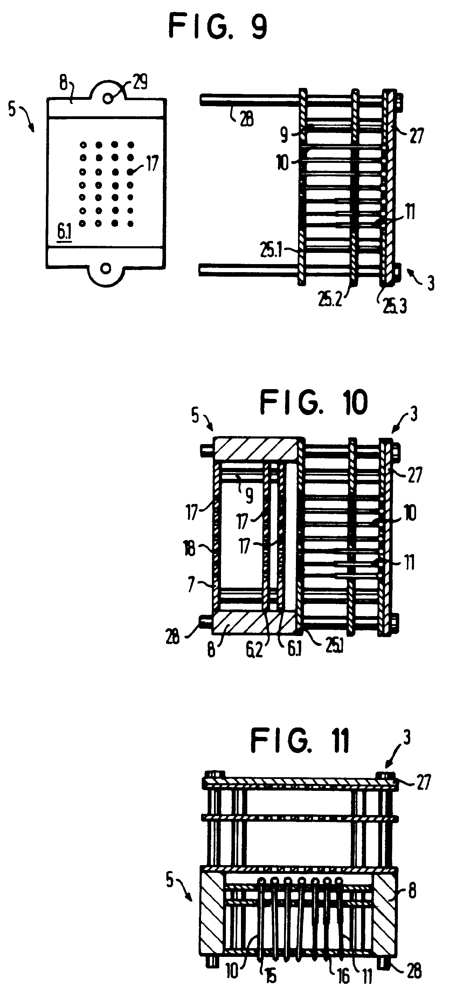

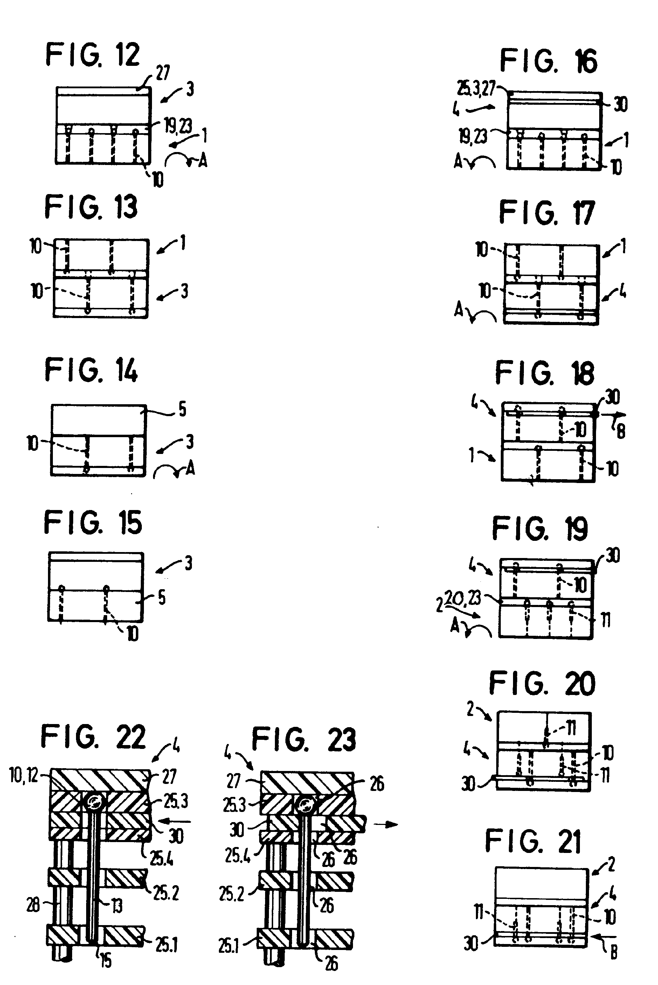

Der Adapter 5 besteht in bekannter Weise - s. Fig. 10 und 11 - aus drei Lochplatten 6.1,6.2 und 7, die in einem Rahmen 8 befestigt und in diesem durch Abstands- und Befestigungsbolzen 9 in gegenseitigem Abstand gehalten sind. Die Lochplatten 6.1-7 sind mit durchgehenden Löchern zur Aufnahme von Adapterstiften 10 einer ersten Ausführungsart und Adapterstiften 11 einer zweiten Ausführungsart vorgesehen. Beide Ausführungsarten sind der Einfachheit halber in den Fig. 1-11 durch lediglich vier Adapterstifte 10 und drei Adapterstifte 11 sowie in den Fig. 16-21 durch jeweils zwei Adapterstifte 10 bzw. 11 dargestellt. Die Adapterstifte beider Ausführungsarten bestehen aus je einem Schaft, dessen eines Ende einen Kopf 12 trägt und dessen anderes Ende als Kontaktende ausgebildet ist. Die Schäfte der Adapterstifte 10 der ersten Ausführungsart sind mit dem Bezugszeichen 13 bezeichnet und weisen über ihre Gesamtlänge den gleichen Durchmesser auf, während die Schäfte der Adapterstifte 11 der zweiten Ausführungsart aus einem, an den Kopf 12 angrenzenden ersten Schaftabschnitt 14.1 und einen sich anschließenden zweiten Schaftabschnitt 14.2 mit geringerem Durchmesser bestehen. Der Durchmesser der ersten Schaftabschnitte 14.1 ist gleich dem Durchmesser der Schäfte 13 der Adapterstifte 10, die in Kontaktenden 15 auslaufen. Die Kontaktenden der Adapterstifte 11 sind mit den Bezugszeichen 16 bezeichnet.

Die Löcher in den Lochplatten 6.1 und 6.2 sind mit den Bezugszeichen 17 bezeichnet und weisen einen Durchmesser auf, der kleiner als der Durchmesser der Köpfe 12 der Adapterstifte 10 sowie 11 und zumindest gleich dem Durchmesser der Schäfte 13 ist. Die Löcher der äußeren Lochplatte 6.1 sind ebenfalls wie die Löcher 17 der darunter befindlichen Lochplatte 6.2 an den Punkten des Rasters der Prüfkontaktanordnung eines nicht gezeigten Leiterplattenprüfgeräts, jedoch etwas versetzt zueinander, angeordnet. Wie in Fig. 11 dargestellt, sind die Adapterstifte 10 und 11 an ihren durch die Lochplatte 6.1 abgestützten Köpfen 12 hängend im Adapter 5 angeordnet. Ihre den Kontaktenden 15 bzw. 16 benachbarten Schaftabschnitte ragen durch Löcher 17 bzw. 18 in der verbleibenden Lochplatte 7 hindurch. Die Durchmesser der Löcher 17 und 18 sind entsprechend dem Durchmesser der jeweils aufgenommenen Schäfte 13 bzw. der zweiten Schaftabschnitte 14.2 der Adapterstifte 10 und 11 ausgebildet. Die Löcher 17 und 18 sind teils im Raster und teils außer Raster, erkenntlich an den etwas schief hängenden Adapterstiften 10 - zweiter und vierter Stift von links in Fig. 11 - und 11 - erster Stift von rechts in Fig. 11 -, angeordnet und bilden ein Lochmuster, das dem Lochmuster der Prüfkontakte der mit dem Leiterplattenprüfgerät zu prüfenden Leiterplatte übereinstimmt.

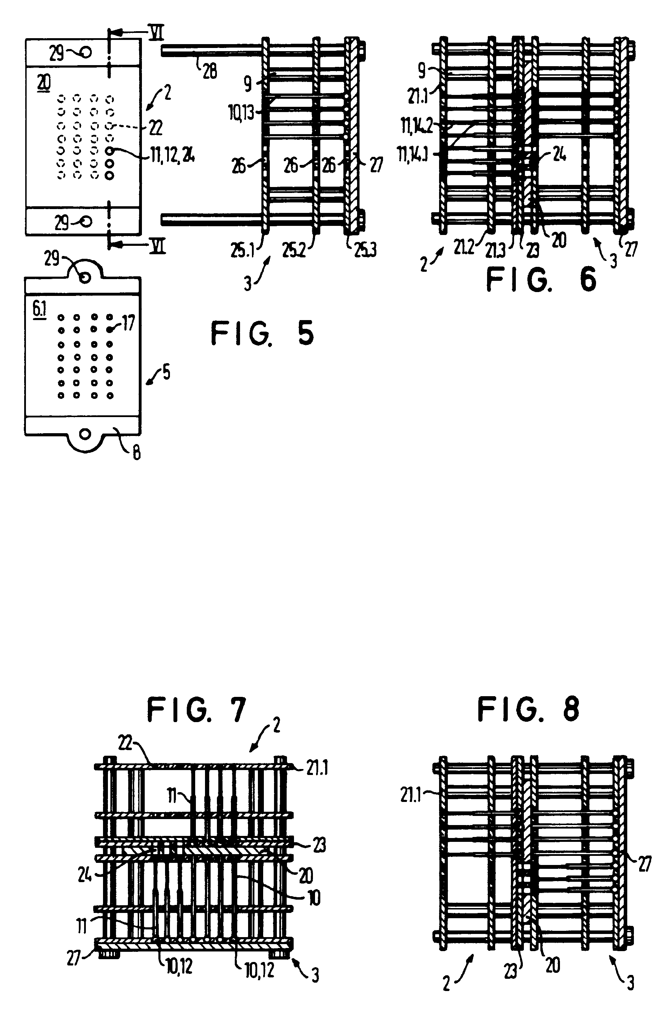

Das in den Fig. 2-4 gezeigte Hauptmagazin 1 ist mit den Adapterstiften 10 und das in den Fig. 6-8 dargestellte Hauptmagazin 2 mit den Adapterstiften 11 gefüllt. Entgegen der Zeichnung sind in der Praxis in den Hauptmagazinen eine größere Anzahl von Löchern zur Aufnahme von Adapterstiften als im Adapter ausgebildet.

An den Außenseiten der Hauptmagazine 1 und 2 sind Selektionsplatten 19 bzw. 20 lösbar befestigt, die Durchgangslöcher gleichen Durchmesser aufweisen, welche unterschiedliche Lochmuster bilden. Das Lochmuster der Durchgangslöcher in der Selektionsplatte 19 entspricht dem Lochmuster der Löcher 17 und das der Durchgangslöcher in der Selektionsplatte 20 dem Lochmuster der Löcher 18 in der Lochplatte 7 des Adapters 5. Ansonsten ist der Aufbau der Hauptmagazine 1 und 2 identisch und nachfolgend beschrieben.

Die Hauptmagazine 1,2 bestehen jeweils aus vier parallel zueinander angeordneten und aneinander befestigten Lochplatten mit durchgehenden Löchern, die an den Punkten des vorgenannten Rasters der Prüfkontaktanordnung des Leiterplattenprüfgeräts koaxial angeordnet und zur Aufnahme der Adapterstifte 10 bzw. 11 bestimmt sind. Drei der Lochplatten sowie ihre Löcher sind mit den Bezugszeichen 21.1,21.2,21.3 bzw. 22 bezeichnet und mittels Befestigungs- und Abstandsbolzen 9 im gegenseitigem Abstand gehalten. Die Löcher 22 weisen einen Durchmesser auf, der kleiner als der Durchmesser der Köpfe 12 und zumindest gleich dem Durchmesser der Schäfte 13 der Adapterstifte 10 ist. Die vierte Lochplatte sowie deren Löcher sind mit den Bezugszeichen 23 bzw. 24 bezeichnet und direkt auf der Außenseite der äußeren Lochplatte 21.3 befestigt. Der Durchmesser der Löcher 24 ist zumindest gleich dem Durchmesser der Köpfe 12 der Adapterstifte 10 und 11, die infolge der vorbeschriebenen Anordnung der Lochplatten 21.1-21.3 und 23 an ihren in den Löchern 24 der Lochplatte 23 aufgenommenen und von der darunter befindlichen Lochplatte 21.3 abgestützten Köpfen 12 hängend im Hauptmagazin 1,2 angeordnet.

Die Selektionsplatte 19 bzw. 20 ist direkt auf der Außenseite der Lochplatte 23 befestigt und mit zu deren Löchern 24 koaxialen und den gleichen Durchmesser aufweisenden Durchgangslöchern versehen, die ebenfalls mit den Bezugszeichen 24 bezeichnet sind. Die Anzahl der Durchgangslöcher 24 ist jedoch kleiner als die der Löcher 22,24 in den Lochplatten 21.1-21.3 bzw. 23; sie entspricht der Anzahl der in den Adapter 5 zu ladenden Adapterstifte 10 bzw. 11.

Das in den Fig. 1-11 im Schnitt dargestellte Zwischenmagazin 3 besteht aus drei parallel zueinander angeordneten, durch Befestigungs- und Abstandsbolzen 9 in gegenseitigem Abstand gehaltene identische Lochplatten 25.1,25.2,25.3 mit durchgehenden Löchern 26, die koaxial an den vorgenannten Rasterpunkten angeordnet sind und einen Durchmesser aufweisen, der zumindest gleich dem Durchmesser der Köpfe 12 der Adapterstifte 10 und 11 ist. Eine lochfreie Verschlußplatte 27 ist auf der Außenseite der Lochplatte 25.3 lösbar mittels Führungsbolzen 28 befestigt, die sich senkrecht zur Ebene der Platten 25.1-25.3,27 erstrecken und um ein Maß über die der Verschlußplatte 27 abgewandte Lochplatte 25.1 überstehen, welches mindestens gleich der Dicke der Hauptmagazine 1, 2 ist. Bohrungen 29 zur Aufnahme der Führungsbolzen 28 sind in den Hauptmagazinen 1 und 2 sowie dem Adapter 5 ausgebildet und ebenso wie die Führungsbolzen 28 zu den Löchern 26 des Zwischenmagazins 3,4 relativ zu den Löchern 22,24 bzw. 17 des Hauptmagazins 1,2 sowie der Lochplatte 6.1 des Adapters 5 so angeordnet, daß diese Löcher 26,22,24,17 bei in den Bohrungen 29 aufgenommenen Führungsbolzen 28 koaxial zueinander ausgerichtet sind. Führungsbolzen 28 und Bohrungen 29 stellen somit eine Ausrichteinrichtung dar.

Das in den Fig. 22 und 23 im Schnitt dargestellte Zwischenmagazin 4 ist mit Ausnahme einer zwischen den Lochplatten 25.3 und 25.2 angeordneten Klemmplatte 30 sowie einer diese abstützenden Lochplatte 25.4 identisch mit dem Zwischenmagazin 3. Die Klemmplatte 30 ist zwischen den Lochplatten 25.3 und 25.4 zwischen einer Offenstellung und einer Schließstellung verschiebbar. Sie ist ebenso wie die Lochplatten 25.1 bis 25.4 mit Löchern 26 versehen, die an den vorgenannten Rasterpunkten angeordnet sind und einen Durchmesser aufweisen, der zumindest gleich dem Durchmesser der Köpfe der Adapterstifte 10 und 11 ist. In der Offenstellung sind die Löcher 26 der Klemmplatte 30 mittig und in der Schließstellung außermittig zu den Löchern 26 der Lochplatten 25.1-25.4 angeordnet. Die Klemmplatte 30 ist durch nicht gezeigte Mittel in Richtung Schließstellung federbeaufschlagt.

Nachstehend ist der in den Fig. 1-11 dargestellte Verfahrensablauf ausgehend von der in Fig. 1 gezeigten Verfahrensstufe beschrieben, in der das mit Adapterstiften 10 gefüllte Hauptmagazin 1 in horizontaler Lage mit nach oben weisender Selektionsplatte 19 neben dem leeren Zwischenmagazin 3 angeordnet ist, welches sich mit vertikal erstreckenden Platten 25.1-25.3 und 27 in einer gegenüber der Horizontalen um 90° gekippten Hochkantstellung befindet; die Verschlußplatte 27 ist dabei auf der dem Hauptmagazin 1 abgewandten Seite des Zwischenmagazins 3 angeordnet.
1. Verfahrensschritt: Das Hauptmagazin 1 wird im Uhrzeigersinn um 90° in die Hochkantstellung gekippt, auf die Führungsbolzen 28 aufgesetzt und entlang derselben bis zur Anlage an das Zwischenmagazin 3 verschoben; das Hauptmagazin 1 und das Zwischenmagazin 3 bilden das in Fig. 2 gezeigte Paket 1,3, in welchem die Selektionsplatte 19 und die Lochplatte 25.1 aneinanderliegen.
2. Verfahrensschritt: Das Paket 1,3 wird im Uhrzeigersinn um 90° bis in die in Fig. 3 gezeigte horizontale Stellung gekippt, in der sich das Hauptmagazin 1 über dem Zwischenmagazin 3 befindet, so daß diejenigen Adapterstifte 10, die in den zu den Löchern 24 der Selektionsplatte 19 koaxialen Löchern 22 und 24 der Lochplatten 21.1-21.3 und 23 sitzen, durch Einwirkung der Schwerkraft mit ihren Köpfen 12 voraus durch die Löcher 24 der Selektionsplatte 19 hindurch in die koaxialen Löcher 26 der Lochplatten 25.1-25.3 des Zwischenmagazins 3 bis zur Anlage an die Verschlußplatte 27 hineinfallen. Auf diese Weise sind die in den Adapter 5 zu ladenden Adapterstifte 10 vom Hauptmagazin 1 in das Zwischenmagazin 3 überführt; es sind der vereinfachten Darstellung halber lediglich die in Fig. 1 in der äußeren rechten Reihe entlang der Schnittlinie II-II fett eingezeichneten vier Adapterstifte. Die verbleibenden drei Adapterstifte, die von den lochfreien Bereichen der Selektionsplatte 19 abgestützt sind, bleiben im Hauptmagazin 1 zurück.
3. Verfahrensschritt: Das Paket 1,3 wird entgegen dem Uhrzeigersinn um 90° bis in die in Fig. 4 gezeigte Stellung gekippt, die abgesehen von der geänderten Verteilung der Adapterstifte 10 zwischen dem Hauptmagazin 1 und dem Zwischenmagazin 3 gleich der in Fig. 2 gezeigten Stellung ist.
4. Verfahrensschritt: Das teilentleerte Hauptmagazin 1 wird durch Verschieben entlang den Führungsbolzen 28 vom teilbeladenen Zwischenmagazin 3 getrennt und um 90° in die horizontale Stellung zurückgekippt. Das teilbeladene Zwischenmagazin 3 bleibt in der Hochkantstellung zurück. Dies ist in Fig. 5 dargestellt, die außerdem das mit Adapterstiften 11 gefüllte Hauptmagazin 2 in horizontaler Lage mit nach oben weisender Selektionsplatte 20 neben dem Zwischenmagazin 3 liegend zeigt.

Mit den Verfahrensschritten 5 bis 7 werden die in den Adapter 5 zu ladenden Adapterstifte 11 - es sind dies der vereinfachten Darstellung halber lediglich die in Fig. 5 in der äußeren rechten Reihe entlang der Schnittlinie VI-VI fett eingezeichneten drei der insgesamt sieben Stifte - aus dem Hauptmagazin 2 durch die Selektionsplatte 20 hindurch in gleicher Weise wie die Adapterstifte 10 aus dem Hauptmagazin 1 nach den Verfahrensschritten 1 bis 3 in das Zwischenmagazin 3 überführt, woraufhin mit dem achten Verfahrensschritt das Hauptmagazin 2 mit den verbleibenden vier Adapterstiften 11 in gleicher Weise wie das Hauptmagazin 1 nach dem Verfahrensschritt 4 vom Zwischenmagazin 3 getrennt wird. Dabei entsprechen die in den Fig. 5-8 gezeigten Verfahrensstufen denjenigen nach den Fig. 1-4. Das mit sämtlichen in den Adapter 5 zu ladenden Adapterstiften 10,11 beladene Zwischenmagazin 3 bleibt in der Hochkantstellung zurück. Dies ist in Fig. 9 dargestellt, die außerdem den leeren Adapter 5 in horizontaler Lage mit nach oben weisender Lochplatte 6.1 neben dem Zwischenmagazin 3 liegend zeigt.

Die im Zwischenmagazin 3 befindlichen Adapterstifte 10,11 werden mit den folgenden vier Verfahrensschritten in den Adapter 5 überführt:
Verfahrensschritt 9: Der leere Adapter 5 wird in gleicher Weise wie die Hauptmagazine 1,2 um 90° in die Hochkantstellung gekippt und an das Zwischenmagazin 3 angesetzt, um das in Fig. 10 gezeigte Paket 3,5 zu bilden, in welchem die Lochplatten 5.1 und 6.1 einander zugewandt sind.
Verfahrensschritt 10: Das Paket 3,5 wird entgegen dem Uhrzeigersinn um 90° bis in die in Fig. 11 gezeigte horizontale Stellung gekippt, in der das Zwischenmagazin 3 über den Adapter 5 angeordnet ist, so daß sämtliche, in den koaxialen Löchern 26 des Zwischenmagazins 3 sitzenden Adapterstifte 10,11 durch Einwirkung der Schwerkraft mit ihren Kontaktenden 15,16 voraus in die Löcher 17,18 der Lochplatten 6.1,6.2 und 7 des Adapters 5 hineinfallen. Der Adapter 5 ist somit mit sämtlichen für die Prüfung der Leiterplatte erforderlichen Adapterstiften 10,11 beladen. Das Zwischenmagazin 3 bleibt im völlig entleerten Zustand zurück.
Verfahrensschritt 11: Der vollständig beladene Adapter 5 wird vom Zwischenmagazin 3 entfernt.
Verfahrensschritt 12: Das leere Zwischenmagazin 3 wird um 90° in die in Fig. 1 gezeigte Hochkantstellung gekippt, woraufhin der Verfahrensablauf erneut beginnen kann.

Gemäß der in den Fig. 12-15 dargestellten Verfahrensvariante wird der Adapter 5 lediglich mit den Adapterstiften 10 der ersten Ausführungsart beladen. Dazu sind die folgenden sechs Verfahrensschritte erforderlich.
Verfahrensschritt 1: Das leere Zwischenmagazin 3 wird mit seiner Lochplatte 25.1 auf die Selektionsplatte 19 des mit den Adapterstiften 10 gefüllten Hauptmagazins 1 aufgesetzt - der Einfachheit halber sind lediglich vier Adapterstifte gezeigt -es entsteht das in Fig. 12 gezeigte Paket 1,3.
Verfahrensschritt 2: Das Paket 1,3 wird, wie mit dem Pfeil A angedeutet, in der Zeichenebene um 180° gekippt, so daß das Hauptmagazin 1, wie in Fig. 13 gezeigt, oberhalb des Zwischenmagazins 3 angeordnet ist und entsprechend dem Lochmuster in der Selektionsplatte 19 die Hälfte der Adapterstifte 10 durch Einwirkung der Schwerkraft mit ihren Köpfen 12 voraus in das Zwischenmagazin 3 überführt wird.
Verfahrensschritt 3: Das teilentleerte Hauptmagazin 1 wird vom beladenen Zwischenmagazin 3 entfernt.
Verfahrensschritt 4: Der leere Adapter 5 wird mit seiner Lochplatte 6.1 auf die Lochplatte 25.1 des Zwischenmagazins 3 aufgesetzt, wodurch das in Fig. 14 gezeigte Paket 3,5 entsteht.
Verfahrensschritt 5: Das Paket 3,5 wird in Richtung des Pfeils A, d.h. in der Zeichenebene, um 180° in die in Fig. 15 gezeigte Stellung gekippt, in der das Zwischenmagazin 3 oberhalb des Adapters 5 angeordnet ist, so daß sämtliche im Zwischenmagazin 3 befindlichen Adapterstifte 10 durch Einwirkung der Schwerkraft mit ihren Kontaktenden 15 voraus in den Adapter 5 überführt werden. Das leere Zwischenmagazin 3 bleibt zurück.
Verfahrensschritt 6: Der beladene Adapter 5 wird von leeren Zwischenmagazin 3 entfernt, worauf der Verfahrensablauf erneut beginnen oder nach Kippen des Zwischenmagazins 3 in die in Fig. 1 gezeigte Hochkantstellung das Beladen des Adapters 5 mit Adapterstiften 11 aus dem Hauptmagazin 2 entsprechend den vorbeschriebenen Verfahrensschritten 5 bis 10 durchgeführt werden kann.

Für den Verfahrensablauf nach den Fig. 16-21 wird statt des Zwischenmagazins 3 das die Klemmplatte 30 aufweisende Zwischenmagazin 4 nach den Fig. 22,23 verwendet. Der Verfahrensablauf ist wie folgt:
Verfahrensschritt 1: Das leere Zwischenmagazin 4 mit in Offenstellung befindlicher Klemmplatte 30 wird mit seiner Lochplatte 25.1 auf die Selektionsplatte 19 des mit Adapterstiften 10 gefüllten Hauptmagazins 1 aufgesetzt - der Einfachheit halber sind lediglich vier Adapterstifte gezeigt -; es entsteht das in Fig. 16 gezeigte Paket 1,4.
Verfahrensschritt 2: Das Paket 1,4 wird, wie mit dem Pfeil A angedeutet, in der Zeichenebene um 180° gekippt, so daß das Hauptmagazin 1, wie in Fig. 17 gezeigt, oberhalb des Zwischenmagazins 4 angeordnet ist und entsprechend dem Lochmuster der Selektionsplatte 19 die Hälfte der Adapterstifte 10 durch Einwirkung der Schwerkraft mit den Köpfen 12 voraus in das Zwischenmagazin 4 überführt wird
Verfahrensschritt 3: Die Klemmplatte 30 wird geschlossen, wie dies mit dem Pfeil B in Fig. 18 angedeutet ist.
Verfahrensschritt 4: Das Paket 1,4 mit geschlossener Klemmplatte 30 wird in Richtung des Pfeiles A, d.h. in der Zeichenebene um 180° gekippt, so daß das teilbeladene Zwischenmagazin 4 über dem teilentleerten Hauptmagazin 1, wie in Fig. 18 gezeigt, angeordnet ist.
Verfahrensschritt 5: Das teilentleerte Hauptmagazin 1 wird entfernt, so daß das teilbeladene Zwischenmagazin 4 zurückbleibt.
Verfahrensschritt 6: Das teilbeladene Zwischenmagazin 4 mit geschlossener Klemmplatte 30 wird mit seiner Lochplatte 25.1 auf die Selektionsplatte 20 des mit Adapterstiften 11 gefüllten Hauptmagazins 2 aufgesetzt - der Einfachheit halber sind lediglich drei Adapterstifte 11 gezeigt; es ergibt sich das in Fig. 19 gezeigte Paket 2,4.
Verfahrensschritt 7: Das Paket 2,4 wird, wie mit der Pfeil A angedeutet, in der Zeichenebene um 180° gekippt, so daß das Hauptmagazin 2, wie in Fig. 20 gezeigt, oberhalb des teilbeladenen Zwischenmagazins 4 angeordnet ist und entsprechend dem Lochmuster der Selektionsplatte 20 zwei Drittel der Adapterstifte 11 durch die Einwirkung der Schwerkraft mit ihren Köpfen 12 voraus in das Zwischenmagazin 4 bis in die in Fig. 20 gezeigte Stellung oberhalb der geschlossenen Klemmplatte 30 überführt wird.
Verfahrensschritt 8: Die Klemmplatte 30 wird, wie mit dem Pfeil B angedeutet, in die Offenstellung verfahren, so daß die Adapterstifte 11 im Zwischenmagazin 4 in die in Fig. 21 gezeigte Stellung fallen, in der sie mit ihren Köpfen 12 der Verschlußplatte 27 anliegen.
Verfahrensschritt 9: Die Klemmplatte 30 wird geschlossen.
Verfahrensschritt 10: Das teilentleerte Hauptmagazin 2 wird vom beladenen Zwischenmagazin 4 entfernt.
Verfahrensschritt 11: Der leere Adapter 5 wird mit seiner Lochplatte 6.1 auf die Lochplatte 25.1 des Zwischenmagazins 4 aufgesetzt, wodurch ein Paket 4,5 entsteht.
Verfahrensschritt 12: Das Paket 4,5 wird ebenfalls in der Zeichenebene um 180° gekippt, so daß das beladene Zwischenmagazin 4 oberhalb des leeren Adapters 5 angeordnet ist.
Verfahrensschritt 13: Die Klemmplatte 30 wird in die Offenstellung verfahren, so daß sämtliche im Zwischenmagazin 4 befindlichen Adapterstifte 10,11 durch Einwirkung der Schwerkraft mit ihren Kontaktenden 15,16 voraus in den Adapter 5 überführt werden.
Verfahrensschritt 14: Der beladene Adapter 5 wird entfernt und das leere Zwischenmagazin 4 steht für eine Wiederholung des Verfahrensablaufes zur Verfügung.

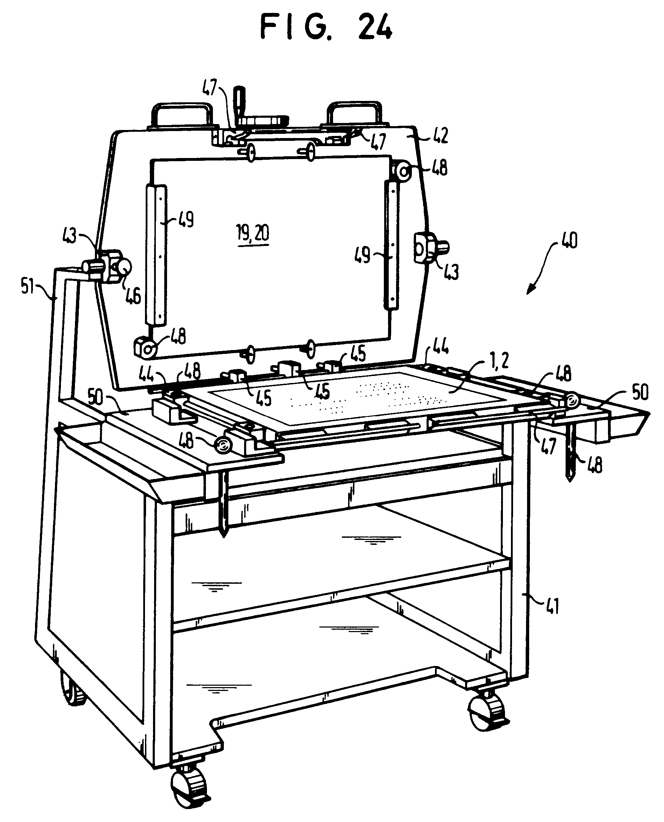

Auch das zweite Ausführungsbeispiel der erfindungsgemäßen Vorrichtung nach Fig. 24 eignet sich sowohl zum Beladen als auch zum Entladen des Adapters und weist zusätzlich zur vorbeschriebenen Vorrichtung eine Transportanordnung 40 auf, mit der das Hauptmagazin 1,2, das Zwischenmagazin und der Adapter relativ zueinander in Positionen transportiert werden können, in denen die Adapterstifte durch Schwerkrafteinwirkung aus dem Hauptmagazin 1,2 in das Zwischenmagazin und aus diesem in den Adapter sowie von letzterem über das Zwischenmagazin zurück in das Hauptmagazin überführt werden können.

Die Transportanordnung 40 umfaßt ein verfahrbares Rahmengestell 41, einer Kippeinrichtung mit einer plattenförmigen Kipphalterung 42 und einem Kipplager 43, eine Schwenkeinrichtung mit einer rahmenförmigen Schwenkhalterung 44 und einem Schwenklager 45, eine Arretiereinrichtung 46, eine Verriegelungseinrichtung 47, eine Ausrichteinrichtung 48 und eine Befestigungseinrichtung 49.

Das verfahrbare Rahmengestell 41 umfaßt eine im wesentlichen horizontale Tischplatte 50, die in ihren beiden rückwärtigen Eckbereichen von je einem vertikalen Stützarm 51 überragt wird. Die plattenförmige Kipphalterung 42 ist mittels des Kipplagers 43 an den freien Enden der Stützarme 51 um eine horizontal verlaufende Kippachse im wesentlichen senkrecht zu ihrer Ebene kippbar gelagert. Die Kippachse verläuft durch den Schwerpunkt der plattenförmigen Kipphalterung 42, welche mittels der Arretiereinrichtung 46 in einer im wesentlichen vertikalen oder Hochkantstellung (s. Fig. 24) festgelegt werden kann. Die Arretiereinrichtung 46 besteht aus zwei verschiebbar geführten Arretierbolzen, die an beiden Stützarmen 51 unter Fehlerbeaufschlagung sperrend in das Kipplager 43 eingreifen. Bei gelöster Arretierung kann die plattenförmige Kipphalterung 42 um wenigstens 180° gekippt werden, wobei sie in zwei im wesentlichen horizontale Stellungen überführbar ist.

Nicht gezeigte Aufspanneinrichtungen dienen zum lösbaren Aufspannen des Zwischenmagazins an der plattenförmigen Kipphalterung 42 sowie des Hauptmagazins 1 bzw. 2 bzw. des Adapters an der rahmenförmigen Schwenkhalterung 44. Letztere ist randseitig über das Schwenklager 45 mit horizontal verlaufender Schwenkachse an dem unteren Randbereich der in der Hochkantstellung befindlichen plattenförmigen Kipphalterung 42 angelenkt und kann auf diese Weise im wesentlichen senkrecht zu ihrer Ebene von beispielsweise der in Fig. 24 gezeigten horizontalen Stellung, in der sie auf der Tischplatte 50 aufliegt, bis zur Anlage an die in der Hochkantstellung befindliche Kipphalterung 42 verschwenkt werden. Mittels der Verriegelungs- einrichtung 47 können beide Halterungen 42,44 zusammen mit jeweils aufgespanntem Zwischenmagazin und Hauptmagazin bzw. Adapter miteinander verriegelt und nach Lösen der Arretiereinrichtung 46 gemeinsam gekippt werden, z.B. bis in beide genannten Horizontalstellungen, in derem einen die Adapterstifte durch Schwerkrafteinwirkung beim Beladen von Hauptmagazin 1,2 in das Zwischenmagazin bzw. beim Zurückladen vom Adapter in das Zwischenmagazin überführt werden. Durch Kippen der miteinander verriegelten Halterungen 42,44 im Uhrzeigersinn (bei Betrachtung der Fig. 24 von links) kann die andere Horizontalstellung erreicht werden, in der die Überführung der Adapterstifte vom Zwischenmagazin in den Adapter beim Beladen bzw. vom Zwischenmagazin in das Hauptmagazin beim Zurückladen erfolgt. Die Verriegelungseinrichtung 47 umfaßt einander entsprechende Verriegelungselemente, die an den den Schwenklager 45 gegenüberliegenden Randbereichen beider Halterungen 42,44 angeordnet sind.

Spiel im Schwenklager 45 und in den Aufspanneinrichtungen wird durch die Ausrichteinrichtung 48 derart ausgeglichen, daß die Löcher des auf die Kipphalterung 42 aufgespannten Zwischenmagazins und diejenigen des auf der Schwenkhalterung 44 aufgespannten Hauptmagazins bzw. Adapters koaxial zueinander ausgerichtet sind, wenn beide Halterungen 42,44 aufeinandergeklappt und mittels der Verriegelungseinrichtung 47 miteinander verriegelt sind. Die Ausrichteinrichtung 48 umfaßt zwei einander diagonal gegenüberliegende Bohrungen in jeder Halterung 42,44 und zwei in diese Bohrungen einsteckbare Führungsbolzen, die bei Nichtgebrauch in die Tischplatte 50, wie in Fig. 24 gezeigt, eingehängt sind.

Die Befestigungseinrichtung 49 umfaßt zwei an der Kipphalterung 42 mit gegenseitigem Abstand angebrachte Befestigungsleisten, die zur lösbaren Befestigung der Selektionsplatte 19 bzw. 20 am Zwischenmagazin dienen. Diese alternative Befestigung der Selektionsplatte 19,20 am Zwischenmagazin erleichtert im Vergleich zur ebenfalls möglichen Befestigung am Hauptmagazin 1 bzw. 2 das Rückladen der Adapterstifte unterschiedlicher Ausführung vom Adapter in das jeweilige Zwischenmagazin und von diesem in das jeweilige Hauptmagazin 1 bzw. 2.

Die erfindungsgemäße Vorrichtung gem. Fig. 24 kann mit geeigneten Mitteln ausgerüstet sein, um die nachfolgend beschriebenen, jedoch nicht gezeigten alternativen Ausführungen des Hauptmagazins und des Adapters einzusetzen.

Statt der in den Fig. 1 bis 11 beschriebenen Ausführung mit drei identischen Lochplatten umfaßt jedes der Hauptmagazine gemäß der alternativen Ausführung lediglich zwei dieser Lochplatten, d.h. die Lochplatte 21,3 und die Lochplatte 21,2, die gegenüber ersterer abstandsveränderlich geführt ist. Lediglich während des Überführens der Adapterstifte vom Hauptmagazin in das Zwischenmagazin entsprechend Fig. 3 wird mittels der vorerwähnten Mittel die der Lochplatte 21,3 aufliegende Lochplatte 21,2 zwecks Abstandsvergrößerung angehoben. Auf diese Weise wird eine ausreichende Führung der Adapterstifte und damit eine einwandfreie Überführung in das Zwischenmagazin erzielt. In gleicher Weise wird die Lochplatte 21,2 während des Rückführens der Adapterstifte vom Zwischenmagazin in das Hauptmagazin angehoben, hier allerdings zum Zweck der Abstandsverringerung und damit einwandfreier Überführung der Adapterstifte mit den Kontaktenden voraus in das Hauptmagazin.

In gleicher Weise ist der Adapter gemäß der alternativen Ausführung mit einer zusätzlichen Lochplatte ausgerüstet, die identisch mit der Lochplatte 6,1 und dieser gegenüber abstandsveränderlich geführt ist. Ferner sind die Lochplatten 6,2 und 7 gemeinsam als Einsatz aus dem Adapter heraus- bzw. in ihn einsetzbar. Während des Überführens der Adapterstifte vom Zwischenmagazin in den Adapter entsprechend Fig. 10,11 mit eingesetztem Einsatz 6.2,7 wird mittels der vorerwähnten Mittel die zusätzliche Lochplatte zwecks Abstandsverringerung und damit einwandfreier Überführung der Adapterstifte in den Adapter angehoben. In gleicher Weise wird während des Rückführens der Adapterstifte vom Adapter, aus dem zu diesem Zweck der Einsatz 6.2,7 entfernt worden ist, in das Zwischenmagazin die zusätzliche Lochplatte angehoben, hier allerdings zum Zweck der Abstandsvergrößerung, um auf diese Weise eine ausreichende Führung der Adpterstifte und damit deren einwandfreie Überführung mit den Köpfen voraus in das Zwischenmagazin zu erzielen. Desweiteren kann die erfindungsgemäße Vorrichtung nach Fig. 24 mit Mitteln ausgerüstet sein, die z.B. während der Überführung der Adapterstifte vom Zwischenmagazin in den Adapter eine Abstandsvergrößerung zwischen Zwischenmagazin und Adapter, ebenfalls zwecks besserer Überführung der Adapterstifte, ermöglichen.

## Patentansprüche

1. Verfahren zum Laden eines Adapters (5) für ein Leiterplattenprüfgerät mit Köpfe (12) und Kontaktenden (15, 16) aufweisenden Adapterstiften (10, 11), bei dem die in den Adapter (5) zu ladenden Adapterstifte (10, 11) aus wenigstens einem Hauptmagazin (1, 2), in welchem sie an den Köpfen (12) hängend angeordnet sind, in ein Zwischenmagazin (3, 4) mit Löchern (26) für die Adapterstifte (10, 11) überführt werden, wobei die Einführung der Adapterstifte (10, 11) in das Zwischenmagazin (3, 4) durch die Schwerkraftwirkung der Adapterstifte (10, 11) erfolgt, und dann die in das Zwischenmagazin (3, 4) überführten Adapterstifte (10, 11) mit den Kontaktenden (15, 16) voraus in den Adapter (5) überführt werden, wobei die Einführung der Adapterstifte (10, 11) in den Adapter (5) durch die Schwerkraftwirkung der Adapterstifte (10, 11) erfolgt,
**dadurch gekennzeichnet**,
daß die Adapterstifte (10, 11) vom Hauptmagazin (1, 2) mit den Köpfen (12) voraus in das Zwischenmagazin (3, 4) überführt werden.

2. Verfahren nach Anspruch 1,
dadurch **gekennzeichnet**,
daß das leere Zwischenmagazin (3) auf das Hauptmagazin (1), in dem die Adapterstifte (10) hängend angeordnet sind, aufgesetzt und zusammen mit diesem um etwa 180° gekippt wird, so daß die Adapterstifte (10) mit den Köpfen (12) voraus in das Zwischenmagazin (3) Überführt werden.

3. Verfahren nach Anspruch 1 oder 2,
dadurch **gekennzeichnet**,
daß in den Adapter (5) zu ladende Adapterstifte (10,11) durch Löcher (24), die in entsprechender Zahl und Anordnung in einer zwischen dem Hauptmagazin (1,2) und dem Zwischenmagazin (3,4) angeordneten Selektionsplatte (19,20) ausgebildet sind, in das Zwischenmagazin (3,4) überführt und verbleibende Adapterstifte (10,11) durch die lochfreien Bereiche der Selektionsplatte (19,20) zurückgehalten werden.

4. Verfahren nach wenigstens einem der vorhergehenden Ansprüche,
dadurch **gekennzeichnet**,
daß die vom Hauptmagazin (1,2) in das Zwischenmagazin (3,4) überführten Adapterstifte (10,11) durch eine lochfreie Verschlußplatte (27) an der dem Hauptmagazin (1,2) gegenüberliegenden Außenseite des Zwischenmagazins (3,4) am Durchfallen durch dasselbe gehindert werden.

5. Verfahren nach wenigstens einem der vorhergehenden Ansprüche,
dadurch **gekennzeichnet**,
daß der Adapter (5) mit seiner im beladenen Zustand die Köpfe (12) der Adapterstifte (10) haltenden Seite auf die der Verschlußplatte (27) abgewandten Seite des beladenen Zwischenmagazins (3) aufgesetzt und sodann zusammen mit diesem um etwa 180° gekippt wird, so daß die Adapterstifte (10) mit den Kontaktenden (15) voraus in den Adapter (5) überführt werden.

6. Verfahren nach wenigstens einem der vorhergehenden Ansprüche,
dadurch **gekennzeichnet**,
daß nach dem Überführen von Adapterstiften (10) aus dem vorgenannten oder ersten Hauptmagazin (1) in das Zwischenmagazin (3,4) weitere in den Adapter (5) zu ladende Adapterstifte (11) aus einem oder mehreren weiteren Hauptmagazinen (2) nacheinanderfolgend mit den Köpfen (12) voraus in das Zwischenmagazin (3,4) überführt werden.

7. Verfahren nach wenigstens einem der vorhergehenden Ansprüche,
dadurch **gekennzeichnet**,
daß das leere oder mit Adapterstiften (10) aus wenigstens einem Hauptmagazin (1) beladene Zwischenmagazin (3) um etwa 90° in eine Hochkantstellung gekippt und nach Ansetzen an das erste Hauptmagazin (1) bzw. ein weiteres, ebenfalls in Hochkantstellung befindliches Hauptmagazin (2) zusammen mit diesem um etwa 90° zurückgekippt wird, so daß die Adapterstifte (10 bzw. 11) aus dem ersten bzw. weiteren Hauptmagazin (1 bzw. 2) mit den Köpfen (12) voraus in das Zwischenmagazin (3) überführt werden.

8. Verfahren nach Anspruch 7,
dadurch **gekennzeichnet**,
daß das mit Adapterstiften (10,11) aus einem oder mehreren Hauptmagazinen (1,2) beladene Zwischenmagazin (3) um etwa 90° in die Hochkantstellung gekippt und nach Ansetzen an den ebenfalls in Hochkantstellung befindlichen Adapter (5) zusammen mit diesem um etwa 90° gekippt wird, so daß die Adapterstifte (10,11) aus dem Zwischenmagazin (3) mit den Kontaktenden (15,16) voraus in den Adapter (5) überführt werden.

9. Verfahren nach Anspruch 5 oder 6,
dadurch **gekennzeichnet**,
daß die aus wenigstens einem Hauptmagazin (1,2) in das Zwischenmagazin (4) überführten Adapterstifte (10,11) durch Schließen einer der Verschlußplatte (27) benachbarten Klemmeinrichtung (30) festgehalten werden, daß dann das Zwischenmagazin (4) mit den festgehaltenen Adapterstiften (10,11) um etwa 180° gekippt und auf den Adapter (5) aufgesetzt wird, so daß nach öffnen der Klemmeinrichtung (30) die Adapterstifte (10,11) mit den Kontaktenden (15,16) voraus in den Adapter (5) überführt werden.

10. Verfahren nach Anspruch 9,
dadurch **gekennzeichnet**,
daß nach dem Schließen der Klemmeinrichtung (30) und Kippen um etwa 180° das beladene Zwischenmagazin (4) auf ein weiteres Hauptmagazin (2) aufgesetzt und zusammen mit diesem wiederum um etwa 180° gekippt wird, so daß nach nochmaligem Lösen der Klemmeinrichtung (30) die Adapterstifte (11) aus dem weiteren Hauptmagazin (2) mit den Köpfen (12) voraus in das Zwischenmagazin (4) überführt werden.

11. Verfahren nach Anspruch 10,
dadurch **gekennzeichnet**,
daß der Adapter (5) mit seiner im beladenen Zustand die Köpfe (12) der Adapterstifte (10,11) haltenden Seite auf die der Verschlußplatte (27) abgewandte Seite des beladenen Zwischenmagazins (4) aufgesetzt und sodann zusammen mit diesem nach Schließen der Klemmeinrichtung (30) um etwa 180° gekippt wird, so daß nach Lösen der Klemmeinrichtung (30) die Adapterstifte (10,11) mit den Kontaktenden (15,16) voraus in den Adapter (5) überführt werden.

12. Verfahren nach wenigstens einem der vorhergehenden Ansprüche,
dadurch **gekennzeichnet**,
daß die Hauptmagazine (1,2) und der Adapter (5) in Anlage an das stationäre Zwischenmagazin gebracht werden.

13. Vorrichtung zum Durchführen des Verfahrens zum Laden eines Adapters (5) für ein Leiterplattenprüfgerät mit Köpfe (12) und Kontaktenden (15,16) aufweisenden Adapterstiften (10,11), nach wenigstens einem der vorhergehenden Ansprüche, mit wenigstens einem Hauptmagazin (1,2), das Löcher (22,24) an Punkten des Rasters der Prüfkontaktanordnung des Leiterplattenprüfgeräts zur Aufnahme von Adapterstiften (10,11) in hängender Anordnung aufweist, mit einem Zwischenmagazin (3,4), das Löcher (26) an Punkten des vorgenannten Rasters zur Aufnahme von Adapterstiften (10,11) aus dem Hauptmagazin (1,2) aufweist, und mit wenigstens einer Selektionsplatte (19,20), in der Löcher (24) an den vorgenannten Rasterpunkten vorgesehen sind, welche ein mit dem Lochmuster des Adapters (5) zumindest teilweise übereinstimmendes Lochmuster bilden,
dadurch **gekennzeichnet**,
daß eine lochfreie Verschlußplatte (27) an einer Seite des Zwischenmagazins (3,4) angeordnet ist, daß die Selektionsplatte (19,20) an der die Köpfe (12) der Adapterstifte (10,11) haltenden Seite des Hauptmagazins (1,2) oder der der Verschlußplatte (27) gegenüberliegenden Seite des Zwischenmagazins (3,4) befestigt ist, daß die Löcher (24) der Selektionsplatte (19,20) als zu den Löchern (22 bzw. 26) des Hauptmagazins (1,2) oder des Zwischenmagazins (3,4) koaxiale Durchgangslöcher (24) mit einem Durchmesser ausgebildet sind, der zumindest gleich dem Durchmesser der Köpfe (12) der Adapterstifte (10,11) ist, daß die Löcher (26) des Zwischenmagazins (3,4) einen Durchmesser aufweisen, der zumindest gleich dem Durchmesser der Durchgangslöcher (24) der Selektionsplatte (19,20) ist, und daß das Hauptmagazin (1,2) und das Zwischenmagazin (3,4) derart zueinander positionierbar sind, daß die Adapterstifte (10,11) durch Schwerkrafteinwirkung aus dem Hauptmagazin (1,2) in das Zwischenmagazin (3,4) überführbar sind.

14. Vorrichtung nach der Anspruch 13,
dadurch **gekennzeichnet**,
daß das Hauptmagazin (1,2) wenigstens zwei mit gegenseitigem Abstand parallel zueinander angeordnete Lochplatten (21.1,21.3) mit koaxial an den vorgenannten Rasterpunkten angeordneten Löchern (22) umfaßt, deren Durchmesser kleiner als der Durchmesser der Köpfe (12) und zumindest gleich dem Durchmesser des jeweils aufzunehmenden Schaftabschnitts der Adapterstifte (10,11) ist.

15. Vorrichtung nach der Anspruch 13 oder 14,
dadurch **gekennzeichnet**,
daß das Zwischenmagazin (3,4) wenigstens zwei mit gegenseitigem Abstand parallel zueinander angeordnete Lochplatten (25.1, 25.2 bzw. 25.3) mit koaxial an den vorgenannten Rasterpunkten angeordneten Löchern (26) mit einem Durchmesser umfaßt, der zumindest gleich dem Durchmesser der Köpfe (12) der Adapterstifte (10,11) ist.

16. Vorrichtung nach Anspruch 15,
dadurch **gekennzeichnet**,
daß das Zwischenmagazin (4) eine zwischen beiden Lochplatten (25.2,25.3) angeordnete und in ihrer Ebene zwischen einer Offenstellung und einer Schließstellung verschiebbare Klemmplatte (30) mit an den vorgenannten Rasterpunkten angeordneten Löchern (26) umfaßt, deren Durchmesser zumindest gleich dem Durchmesser der Köpfe (12) der Adapterstifte (10,11) ist, und daß die Löcher (26) der Klemmplatte (30) bei deren Offenstellung mittig und bei deren Schließstellung außermittig zu den Löchern (26) der Lochplatten (25.1 bis 25.3) angeordnet sind.

17. Vorrichtung nach Anspruch 16,
dadurch **gekennzeichnet**,
daß die Klemmplatte (30) in Richtung Schließstellung federbeaufschlagt ist.

18. Vorrichtung nach wenigstens einem der Ansprüche 13 bis 17,
**gekennzeichnet** durch
eine Transportanordnung (40) zum Transportieren des Hauptmagazins, des Zwischenmagazins und des Adapters relativ zueinander in Positionen, in denen Adapterstife durch Schwerkrafteinwirkung aus dem Hauptmagazin in das Zwischenmagazin und aus diesem in den Adapter überführbar sind.

19. Vorrichtung nach Anspruch 18,
dadurch **gekennzeichnet**,
daß die Transportanordnung (40) eine Kippeinrichtung (42,43) mit einer Kipphalterung (42) zum Halten des Zwischenmagazins und einem Kipplager (43) umfaßt, mit dem die Kipphalterung (42) im wesentlichen senkrecht zu ihrer Ebene um wenigstens etwa 180° kippbar gelagert und in zwei im wesentlichen horizontale Stellungen überführbar ist.

20. Vorrichtung nach Anspruch 19,
**gekennzeichnet** durch
eine Arretiereinrichtung (46) zum lösbaren Festlegen der Kipphalterung (42) für das Zwischenmagazin in einer im wesentlichen vertikalen oder Hochkantstellung des Zwischenmagazins.

21. Vorrichtung nach wenigstens einem der Ansprüche 18 bis 20,
dadurch **gekennzeichnet**,
daß die Transportanordnung (40) eine Schwenkeinrichtung (44,45) umfaßt, die zum Verschwenken des Hauptmagazins bzw. des Adapters in einer sich in Richtung deren Löcher erstreckenden Ebene bis zur Anlage an das Zwischenmagazin und zurück vorgesehen ist.

22. Vorrichtung nach Anspruch 21,
dadurch **gekennzeichnet**,
daß die Schwenkeinrichtung (44, 45) eine Schwenkhalterung (44) zum Halten des Hauptmagazins bzw. des Adapters und ein Schwenklager (45) umfaßt, mit dem die Schwenkhalterung (44) im wesentlichen senkrecht zu ihrer Ebene verschwenkbar gelagert ist.

23. Vorrichtung nach Anspruch 22,
dadurch **gekennzeichnet,**
daß das Schwenklager (45) an der Kipphalterung (42) für das Zwischenmagazin befestigt ist.

24. Vorrichtung nach Anspruch 22 oder 23,
**gekennzeichnet** durch
eine Verriegelungseinrichtung (47) zur lösbaren Verriegelung des Hauptmagazins bzw. des Adapters oder deren Schwenkhalterung (44) mit dem Zwischenmagazin bzw. mit dessen Kipphalterung (42).

25. Vorrichtung nach wenigstens einem der Ansprüche 19 bis 24,
**gekennzeichnet** durch eine Befestigungseinrichtung (49) zum lösbaren Befestigen der Selektionsplatte (19,20) am Zwischenmagazin bzw. dessen Kipphalterung (42) und/oder am Hauptmagazin bzw. an dessen Schwenkhalterung (44).

26. Vorrichtung nach wenigstens einem der Ansprüche 13 bis 25,
**gekennzeichnet** durch
eine Ausrichteinrichtung (28,29) zum Ausrichten des Hauptmagazins (1,2) bzw. des Adapters (5) und des Zwischennagazins (3,4) derart, daß deren Löcher (22,24;17;26) koaxial zueinander ausgerichtet sind.

27. Vorrichtung nach Anspruch 26,
dadurch **gekennzeichnet**,
daß die Ausrichteinrichtung (28,29) wenigstens zwei an der Kipphalterung für das Zwischenmagazin bzw. am Zwischenmagazin (3,4) selbst befestigte und an dessen der Verschlußplatte (27) abgewandten Seite vorstehende Führungsbolzen (28) und entsprechende Bohrungen (29) im Hauptmagazin (1,2) und Adapter (5) bzw. in deren Schwenkhalterung zur Aufnahme der Führungsbolzen (28) umfaßt.

28. Vorrichtung nach Anspruch 26,
dadurch **gekennzeichnet**,
daß die Ausrichteinrichtung (48) zwei Führungsbolzen (48) und jeweils zwei entsprechende Bohrungen (48) im Zwischenmagazin bzw. dessen Kipphalterung (42) sowie im Hauptmagazin und Adapter bzw. in deren Schwenkhalterung (44) zur Aufnahme der Führungsbolzen (48) umfaßt.

29. Vorrichtung nach wenigstens einem der Ansprüche 19 bis 28,
dadurch **gekennzeichnet**,
daß die Transportanordnung (40) ein verfahrbares Rahmengestell (41) umfaßt, an dem die Kipphalterung (42) für das Zwischenmagazin mittels des Kipplagers (43) kippbar gelagert ist.

## Claims

1. A method of loading an adapter (5) for a printed circuit board testing device with adapter pins (10, 11) having heads (12) and contact ends (15, 16), in which the adapter pins (10, 11) to be loaded into the adapter (5) are transferred from at least one main magazine (1, 2), in which they are arranged hanging by their heads (12), into an intermediate magazine (3, 4) having holes (26) for the adapter pins (10, 11), whereby the introduction of the adapter pins (10, 11) into the intermediate magazine (3, 4) is achieved by the effect of gravity on the adapter pins (10, 11), and then the adapter pins (10, 11) that have been transferred into the intermediate magazine (3, 4) are transferred with the contact ends (15, 16) first into the adapter (5) by the effect of gravity on the adapter pins (10, 11),
characterised in that,
the adapter pins (10, 11) are transferred from the main magazine (1, 2) into the intermediate magazine (3, 4) with their heads (12) first.

2. A method according to claim 1,
characterised in that,
the empty intermediate magazine (3) is placed on the main magazine (1) in which the adapter pins (10) are hanging, and tilted together therewith through about 180° so that the adapter pins (10) are transferred with the heads (12) first into the intermediate magazine (3).

3. A method according to claim 1 or claim 2,
characterised in that,
the adapter pins (10, 11) to be loaded into the adapter (5) are transferred into the intermediate magazine (3, 4) through holes (24) that are made in a corresponding number and arrangement in a selection plate (19, 20) arranged between the main magazine (1, 2) and the intermediate magazine (3, 4) and any remaining adapter pins (10, 11) are held back by the regions of the selection plate (19, 20) without holes.

4. A method according to at least one of the preceding claims,
characterised in that,
the adapter pins (10, 11) transferred from the main magazine (1, 2) to the intermediate magazine (3, 4) are prevented from falling through by means of a closing plate (27) without holes on the outer side of the intermediate magazine (3, 4) remote from the main magazine (1, 2).

5. A method according to at least one of the preceding claims,
characterised in that,
the adapter (5) is placed with its side that holds the heads (12) of the adapter pins (10) when in the loaded state, on the side of the loaded intermediate magazine (3) remote from the closing plate (27) and then tilted together therewith through about 180° so that the adapter pins (10) are transferred with the contact ends (15) first into the adapter (5).

6. A method according to at least one of the preceding claims,
characterised in that,
after the adapter pins (10) have been transferred from the aforementioned or first main magazine (1) into the intermediate magazine (3, 4) further adapter pins (11) to be loaded into the adapter (5) from one or several further main magazines (2) are successively transferred with heads first (12) into the intermediate magazine (3, 4).

7. A method according to at least one of the preceding claims,
characterised in that,
the intermediate magazine (3) that is empty or loaded with adapter pins (10) from at least one main magazine (1) is tilted through about 90° so that it is on edge and after being attached to the first main magazine (1) or a further main magazine (2) likewise positioned on edge, is tilted back together with it through about 90° so that the adapter pins (10 or 11) are transferred from the first or from the further main magazine (1 or 2) with their heads (12) first into the intermediate magazine (3).

8. A method according to claim 7,
characterised in that,
the intermediate magazine (3) loaded with adapter pins (10, 11) from one or more main magazines (1, 2) is tilted through about 90° so that it is on edge and, after attaching it to the adapter (5) that is likewise on edge, is tilted together with it through about 90° so that the adapter pins (10, 11) are transferred from the intermediate magazine (3) with their contact ends (15, 16) first into the adapter (5).

9. A method according to claim 5 or claim 6,
characterised in that,
the adapter pins (10, 11) transferred from at least one main magazine (1, 2) into the intermediate magazine (4) are held by closing a clamping device (30) that is adjacent to the closing plate (27) and that the intermediate magazine (4) with the held adapter pins (10, 11) is then tilted through about 180° and placed on the adapter (5) so that, after opening the clamping device (30), the adapter pins (10, 11) are transferred into the adapter (5) with the contact ends (15, 16) first.

10. A method according to claim 9,
characterised in that,
after closing the clamping device (30) and tilting through about 180° the loaded intermediate magazine (4) is placed on a further main magazine (2) and tilted together with it through about 180° so that, after re-releasing the clamping device (30) the adapter pins (11) are transferred from the further main magazine (2) with their heads (12) first into the intermediate magazine (4).

11. A method according to claim 10,
characterised in that,
the adapter (5) is placed with its side that holds the heads (12) of the adapter pins (10, 11) when in the loaded state, on to the side of the loaded intermediate magazine (4) remote from the closing plate (27) and then tilted together with it, after closing the clamping device (30), through about 180° so that, after releasing the clamping device (30), the adapter pins (10, 11) are transferred with their contact ends (15, 16) first into the adapter (5).

12. A method according to at least one of the preceding claims,
characterised in that,
the main magazine (1, 2) and the adapter (5) are moved into contact with the stationary intermediate magazine.

13. Apparatus for carrying out the method of loading an adapter (5) for a printed circuit board testing device with adapter pins (10, 11) having heads (12) and contact ends (15, 16), according to at least one of the preceding claims, comprising at least one main magazine (1, 2) which has holes (22, 24) for receiving hanging adapter pins (10, 11), arranged at the points of the grid of the test contact arrangement of the printed circuit board testing device, an intermediate magazine (3, 4) that has holes (26) at the points of the aforementioned grid for receiving adapter pins (10, 11) from the main magazine (1, 2), and at least one selection plate (19, 20) in which holes (24) are provided at the aforementioned grid points to form a hole pattern that corresponds at least in part to the hole pattern of the adapter (5),
characterised in that,
a hole-free closing plate (27) is arranged on one side of the intermediate magazine (3, 4), in that the selection plate (19, 20) is fastened to the side of the main magazine (1, 2) that holds the heads (12) of the adapter pins (10, 11) or to the side of the intermediate magazine (3, 4) opposite the closing plate (27), in that the holes (24) of the selection plate (19, 20) are formed as through holes (24) that are coaxial with the holes (22 or 26) of the main magazine (1, 2) or of the intermediate magazine (3, 4) and have a diameter that is at least equal to the diameter of the heads (12) of the adapter pins (10, 11), in that the holes (26) of the intermediate magazine (3, 4) have a diameter that is at least equal to the diameter of the through holes (24) of the selection plate (19, 20), and in that the main magazine (1, 2) and the intermediate magazine (3, 4) are so positionable one to the other that the adapter pins (10, 11) are transferred out of the main magazine (1, 2) into the intermediate magazine (3, 4) under the effect of gravity.

14. Apparatus according to claim 13,
characterised in that,
the main magazine (1, 2) comprises at least two parallel, spaced apart perforated plates (21.1, 21.3) having holes (22) arranged coaxially at the aforementioned grid points, of which the diameter is smaller than the diameter of the heads (12) and at least equal to the diameter of the shaft sections of the respective adapter pins (10, 11) to be accommodated.

15. Apparatus according to claim 13 or 14,
characterised in that,
the intermediate magazine (3, 4) comprises at least two parallel, spaced apart perforated plates (25.1, 25.2 or 25.3) having holes (26) arranged coaxially at the aforementioned grid points, of which the diameter is at least equal to the diameter of the heads (12) of the adapter pins (10, 11).

16. Apparatus according to claim 15,
characterised in that,
the intermediate magazine (4) comprises a clamping plate (30) arranged between two of the perforated plates (25.2, 25.3) and moveable in their plane between an open and a closed position, having holes (26) at the aforementioned grid points of which the diameter is at least equal to the diameter of the heads (12) of the adapter pins (10, 11), and in that the holes (26) of the clamping plate (30) are in its open position arranged centrally and in their closed position eccentrically of the holes (26) of the perforated plates (25.1 to 25.3).

17. Apparatus according to claim 16,
characterised in that,
the clamping plate (30) is spring-loaded towards its closing position.

18. Apparatus according to at least one of claims 13 to 17,
characterised by
a transport device (40) for transporting the main magazine, the intermediate magazine and the adapter relative to one another into positions in which adapter pins can be transferred by the effect of gravity from the main magazine into the intermediate magazine and thence into the adapter.

19. Apparatus according to claim 18,
characterised in that,
the transport device (40) includes a tilting device (42, 43) with a tilting holder (42) to hold the intermediate magazine and a tilting bearing (43) by means of which the tilting holder (42) is mounted to be tiltable through at least 180° substantially at right angles to its plane and can be transferred into two substantially horizontal positions.

20. Apparatus according to claim 19,
characterised by
an arresting device (46) to releasably arrest the tilting holder (42) for the intermediate magazine in a substantially vertical or on-edge position of the intermediate magazine.

21. Apparatus according to at least one of claims 18 to 20,
characterised in that,
the transport device (40) includes a pivoting device (44, 45) that serves to pivot the main magazine or the adapter in a plane extending in the direction of the holes therein into contact with the intermediate magazine and back.

22. Apparatus according to claim 21,
characterised in that,
the pivoting device (44, 45) includes a pivoting holder (44) to hold the main magazine or the adapter and a pivoting bearing (45) by means of which the pivoting holder (44) is pivotably mounted substantially at right angles to its plane.

23. Apparatus according to claim 22,
characterised in that,
the pivoting bearing (45) is fixed to the tilting holder (42) for the intermediate magazine.

24. Apparatus according to claim 22 or 23,
characterised by
a locking device (47) for releasably locking the main magazine or the adapter or the pivoting holder (44) thereof to the intermediate magazine or to the tilting holder (42) thereof.

25. Apparatus according to at least one of claims 19 to 24,
characterised by
a fastening device (49) for releasably fastening the selection plate (19, 20) to the intermediate magazine or to the tilting holder (42) thereof and/or to the main magazine or to the pivoting holder (44) thereof.

26. Apparatus according to at least one of claims 13 to 25,
characterised by
an aligning device (28, 29) for aligning the main magazine (1, 2) or the adapter (5) and the intermediate magazine (3, 4) so that their holes (22, 24; 17; 26) are aligned coaxially to one another.

27. Apparatus according to claim 26,
characterised in that,
the aligning device (28, 29) comprises at least two guide bolts (28) fastened to the tilting holder for the intermediate magazine or to the intermediate magazine (3, 4) itself and projecting on the side thereof facing away from the closing plate (27), and corresponding bores (29) in the main magazine (1, 2) and adapter (5) or in the pivoting holder thereof to receive the guide bolts (28).

28. Apparatus according to claim 26,
characterised in that,
the aligning device (48) comprises two guide bolts (48) and two respective corresponding bores (48) in the intermediate magazine or in the tilting holder (42) thereof and in the main magazine and adapter or in the pivoting holder (44) thereof to receive the guide bolts (48).

29. Apparatus according to at least one of claims 19 to 28,
characterised in that,
the transport device (40) comprises a moveable frame stand (41) on which the tilting holder (42) for the intermediate magazine is tiltably mounted by means of the tilting bearing (43).

## Revendications

1. Procédé pour garnir un adaptateur (5) pour un appareil de contrôle de cartes à circuits imprimés au moyen de broches (10, 11) d'adaptateur pourvues de têtes (12) et d'extrémités de contact (15, 16), dans lequel les broches (10, 11) d'adaptateur à mettre en place dans l'adaptateur (5) sont transférées d'au moins un magasin (1, 2) principal, dans lequel elles sont suspendues par la tête (12), dans un magasin (3, 4) intermédiaire pourvu de trous (26) pour les broches (10, 11) d'adaptateur, l'introduction des broches (10, 11) d'adaptateur dans le magasin (3, 4) intermédiaire se faisant par l'action du poids des broches (10, 11) d'adaptateur, et les broches (10, 11) d'adaptateur transférées dans le magasin (3, 4) intermédiaire étant amenées extrémités de contact (15, 16) en avant dans l'adaptateur (5), l'introduction des broches (10, 11) d'adaptateur dans l'adaptateur (5) se faisant par l'action du poids desdites broches (10, 11) d'adaptateur, caractérisé par le fait que les broches (10, 11) d'adaptateur sont transférées tête (12) en avant du magasin (1, 2) principal dans le magasin (3, 4) intermédiaire.

2. Procédé selon la revendication 1, caractérisé par le fait que l'on place le magasin (3) intermédiaire sur le magasin (1) principal dans lequel les broches (10) d'adaptateur sont suspendues et on le fait pivoter avec celui-ci de 180° environ, de telle sorte que les broches (10) d'adaptateur sont transférées tête (12) en avant dans la magasin (3) intermédiaire.

3. Procédé selon la revendication 1 ou la revendication 2, caractérisé par le fait que des broches (10, 11) d'adaptateur à mettre en place dans l'adaptateur (5) sont transférées dans le magasin (3, 4) intermédiaire au travers de trous (24) qui sont ménagés en nombre et avec une disposition adaptés dans une plaque de sélection (19, 20) disposée entre le magasin (1, 2) principal et le magasin (3, 4) intermédiaire et que les les broches (10, 11) d'adaptateur restantes sont retenues par les zones sans trous de la plaque de sélection (19, 20).

4. Procédé selon au moins une des revendications précédentes, caractérisé par le fait que les broches (10, 11) d'adaptateur qui sont transférées du magasin (1, 2) principal dans le magasin (3, 4) intermédiaire sont retenues par une plaque (27) de fermeture sans trous qui est disposée sur la face extérieure du magasin (3, 4) intermédiaire en vis-à-vis du magasin (1, 2) principal.

5. Procédé selon au moins une des revendications précédentes, caractérisé par le fait que l'on applique l'adaptateur (5) par sa face qui retient les têtes (12) des broches (10) d'adaptateur à l'état garni sur la face du magasin (3) intermédiaire éloignée de la plaque d'obturation (27) puis on fait pivoter l'adaptateur et la plaque de 180° environ de telle sorte que les broches (10) d'adaptateur soient transférées extrémités de contact (15) en avant dans l'adaptateur (5).

6. Procédé selon au moins une des revendications précédentes, caractérisé par le fait que, après avoir transféré des broches (10) d'adaptateur du magasin (1) principal mentionné précédemment ou du premier magasin principal dans le magasin (3, 4) intermédiaire, on transfère tête (12) en avant d'autres broches (11) d'adaptateur à mettre en place dans l'adaptateur (5) d'un ou de plusieurs autre(s) magasin(s) (2) principal(aux) dans le magasin (3, 4) intermédiaire.

7. Procédé selon au moins une des revendications précédentes, caractérisé par le fait que l'on fait pivoter de 90° environ, pour l'amener sur chant, le magasin (3) intermédiaire vide ou chargé de broches (10) d'adaptateur provenant d'au moins un magasin (1) principal et, après l'avoir appliqué contre le premier magasin (1) principal ou un autre magasin (2) principal également placé sur chant, on le ramène avec ce dernier dans sa position par pivotement de 90° environ de telle sorte que les broches (10, 11) d'adaptateur soient transférées tête (12) en avant du premier magasin ou de l'autre magasin (1 ou 2) principal dans le magasin (3) intermédiaire.

8. Procédé selon la revendication 7, caractérisé par le fait que l'on fait pivoter de 90° environ, pour l'amener sur chant, le magasin (3) intermédiaire chargé de broches (10, 11) d'adaptateur provenant d'un ou de plusieurs magasin(s) (1, 2) principal(aux) et, après l'avoir appliqué contre l'adaptateur (5) également placé sur chant, on le fait pivoter de 90° environ avec ledit adaptateur de telle sorte que les broches (10, 11) d'adaptateur soient transférées extrémités de contact (15, 16) en avant du magasin (3) intermédiaire dans l'adaptateur (5).

9. Procédé selon la revendication 5 ou la revendication 6, caractérisé par le fait que les broches (10, 11) d'adaptateur transférées d'au moins un magasin (1, 2) principal dans le magasin (4) intermédiaire sont tenues par fermeture d'un dispositif de blocage (30) disposé au voisinage de la plaque 27 de fermeture, par le fait que l'on fait pivoter de 180° environ le magasin (4) intermédiaire avec les broches (10, 11) tenues fermement et on le place sur l'adaptateur (5) de telle sorte qu'après ouverture du dispositif de blocage (30) les broches (10, 11) d'adaptateur soient transférées extrémités de contact (15, 16) en avant dans l'adaptateur (5).

10. Procédé selon la revendication 9, caractérisé par le fait qu'après avoir fermé le dispositif de blocage (30) et fait pivoter de 180° environ le magasin (4) intermédiaire chargé, on place celui-ci sur un autre magasin (2) principal et on le fait pivoter de nouveau de 180° environ avec celui-ci de telle sorte qu'après avoir libéré le dispositif de blocage (30) les broches (11) d'adaptateur soient transférées tête (12) en avant du magasin (2) principal supplémentaire dans le magasin (4) intermédiaire.

11. Procédé selon la revendication 10, caractérisé par le fait que l'on applique l'adaptateur (5) avec sa face qui tient les têtes (12) des broches (10, 11) d'adaptateur à l'état garni sur la face du magasin (4) intermédiaire chargé éloignée de la plaque de fermeture (27) et après avoir fermer le dispositif de blocage (30) on le fait pivoter de 180° environ avec ledit magasin intermédiaire de telle sorte qu'après ouverture du dispositif de blocage (30) les broches (10,11) d'adaptateur soient transférées extrémités de contact (15, 16) en avant dans l'adaptateur (5).

12. Procédé selon au moins une des revendications précédentes, caractérisé par le fait que l'on amène les magasins (1,2) principaux et l'adaptateur (5) en contact avec le magasin intermédiaire fixe.

13. Dispositif pour la mise en oeuvre du procédé selon l'une au moins des revendications précédentes pour garnir un adaptateur (5) pour un appareil de contrôle de cartes à circuits imprimés au moyen de broches (10, 11) d'adaptateur pourvues de têtes (12) et d'extrémités de contact (15, 16), comportant au moins un magasin (1, 2) principal qui présente des trous (22, 24) en des points du réseau du système de contacts de contrôle de l'appareil de contrôle de cartes à circuits imprimés prévus pour recevoir des broches (10, 11) d'adaptateur suspendues, un magasin (3, 4) intermédiaire qui présente des trous (22, 24) en des points du réseau mentionné précédemment pour recevoir des broches (10, 11) d'adaptateur suspendues et au moins une plaque de sélection (19, 20) dans laquelle des trous (24) sont prévus aux points mentionnés du réseau, lesquels trous forment un dessin qui correspond au moins partiellement au dessin des trous de l'adaptateur (5), caractérisé par le fait qu'une plaque de fermeture (27) sans trous est disposée sur une face du magasin (3, 4) intermédiaire, par le fait que la plaque de sélection (19, 20) est fixée sur la face du magasin (1, 2) principal qui tient les têtes (12) des broches (10, 11) d'adaptateur ou sur la face du magasin (3, 4) intermédiaire située en vis-à-vis de la plaque de fermeture (27), par le fait que les trous (24) de la plaque de sélection (19, 20) sont agencés sous la forme de trous (24) débouchants coaxiaux avec les trous (22 ou 26) du magasin (1, 2) principal ou du magasin (3, 4) intermédiaire, dont le diamètre est au moins égal à celui des têtes (12) des broches (10, 11) d'adaptateur, par le fait que les trous (26) du magasin (3, 4) intermédiaire ont un diamètre au moins égal à celui des trous débouchants (24) de la plaque de sélection (19, 20) et par le fait que le magasin (1, 2) principal et le magasin (3, 4) intermédiaire peuvent être positionnés l'un par rapport à l'autre de manière telle que les broches (10, 11) d'adaptateur soient transférés par gravité du magasin (1, 2) principal dans le magasin (3, 4) intermédiaire.

14. Dispositif selon la revendication 13, caractérisé par le fait que le magasin (1, 2) principal comporte au moins deux plaques perforées (21.1, 21.3) mutuellement parallèles et espacées l'une de l'autre avec disposés coaxialement aux points mentionnés du réseau des trous (22) dont le diamètre est inférieur au diamètre des têtes (12) et au moins égal au diamètre de la partie de tige des broches (10, 11) d'adaptateur qu'ils doivent recevoir.

15. Dispositif selon la revendication 13 ou la revendication 14, caractérisé par le fait que le magasin (3, 4) intermédiaire comporte au moins deux plaques perforées (251.1, 25.2 ou 25.3) mutuellement parallèles et espacées l'une de l'autre avec disposés coaxialement aux points mentionnés du réseau des trous (26) dont le diamètre est au moins égal au diamètre des têtes (12) des broches (10, 11) d'adaptateur.

16. Dispositif selon la revendication 15, caractérisé par le fait que le magasin (4) intermédiaire comporte une plaque de blocage (30) qui est disposée entre les deux plaques perforées (25.2, 25.3), peut coulisser dans son plan entre une position ouverte et une position fermée et, aux points mentionnés du réseau, est pourvue de trous (26) dont le diamètre est au moins égal au diamètre des têtes (12) des broches (10, 11) d'adaptateur et par le fait que les trous (26) de la plaque de blocage (30), lorsque cette dernière est en position ouverte, sont centrés et, lorsque celle-ci est en position fermée, sont décentrés par rapport aux trous (26) des plaques perforées (25.1 à 25.3).

17. Dispositif selon la revendication 16, caractérisé par le fait que la plaque de blocage (30) est sollicitée par ressort dans la direction de fermeture.

18. Dispositif selon au moins une des revendications 13 à 17, caractérisé par un dispositif de transport (40) destiné au transport du magasin principal, du magasin intermédiaire et de l'adaptateur les uns par rapport aux autres dans des positions dans lesquelles les broches d'adaptateur sont transférées par gravité du magasin principal dans le magasin intermédiaire et de celui-ci dans l'adaptateur.

19. Dispositif selon la revendication 18, caractérisé par le fait que le dispositif de transport (40) comprend un dispositif de pivotement (42, 43) avec un support pivotant (42) destiné à supporter le magasin intermédiaire et un palier d'articulation (43) par l'intermédiaire duquel le support pivotant (42) est monté avec possibilité de pivotement de 180° environ sensiblement perpendiculairement à son plan et peut être amené dans deux positions sensiblement horizontales.

20. Dispositif selon la revendication 19, caractérisé par un dispositif d'arrêt (46) pour immobiliser avec possibilité de libération le support pivotant (42) pour le magasin intermédiaire dans une position du magasin intermédiaire sensiblement verticale ou sur chant.

21. Dispositif selon au moins une des revendications 18 à 20, caractérisé par le fait que le dispositif de transport (40) comprend un dispositif de pivotement (44, 45) destiné à faire pivoter le magasin principal ou l'adaptateur dans un plan qui s'étend dans la direction des trous, jusqu'à ce que ledit magasin ou l'adaptateur vienne en appui sur le magasin intermédiaire et vice-versa.

22. Dispositif selon la revendication 21, caractérisé par le fait que le dispositif de pivotement (44, 45) comprend un support pivotant (44) destiné à supporter le magasin principal ou l'adaptateur et un palier d'articulation (45) par l'intermédiaire duquel le support pivotant (44) est monté avec possibilité de pivotement sensiblement perpendiculairement à son plan.

23. Dispositif selon la revendication 22, caractérisé par le fait que le palier d'articulation (45) est fixé sur le support pivotant (42) pour le magasin intermédiaire.

24. Dispositif selon la revendication 22 ou la revendication 23, caractérisé par un dispositif de verrouillage (47) pour verrouiller avec possibilité de libération le magasin principal ou l'adaptateur ou encore leur support pivotant (44) sur le magasin intermédiaire ou le support pivotant (42) de celui-ci.

25. Dispositif selon au moins une des revendications 19 à 24, caractérisé par un dispositif de fixation (49) pour fixer de manière libérable la plaque de sélection (19, 20) sur le magasin intermédiaire ou son support pivotant (42) et/ou sur le magasin principal ou le support pivotant (44) de celui-ci.

26. Dispositif selon au moins une des revendications 13 à 25, caractérisé par un dispositif de centrage (28, 29) pour aligner le magasin principal (1, 2) ou l'adaptateur (5) et le magasin (3, 4) intermédiaire de telle sorte que leurs trous (22, 24; 17, 26) soient mutuellement coaxiaux.

27. Dispositif selon la revendication 26, caractérisé par le fait que le dispositif de centrage (28, 29) comprend au moins deux pieds (28) de guidage qui sont fixés sur le support pivotant pour le magasin intermédiaire ou sur le magasin (3, 4) intermédiaire lui-même et font saillie sur la face de celui-ci éloignée de la plaque de fermeture (27) ainsi que des perçages (29) correspondants qui sont disposés dans le magasin (1, 2) principal et l'adaptateur (5) ou dans le support pivotant de ceux-ci et reçoivent les pieds de guidage (28).

28. Dispositif selon la revendication 26, caractérisé par le fait que le dispositif de centrage (48) comprend deux pieds (28) de guidage et respectivement deux perçages (29) adaptés dans le magasin intermédiaire ou dans le support pivotant (42) de celui-ci et dans le magasin principal et l'adaptateur ou dans leur support pivotant (44) qui reçoivent les pieds de guidage (28).

29. Dispositif selon au moins une des revendications 19 à 28, caractérisé par le fait que le dispositif de transport (40) comprend un bâti (41) sur lequel le support pivotant (42) pour le magasin intermédiaire est monté pivotant au moyen du palier d'articulation (43).
